**Europäisches Patentamt**

**European Patent Office**

**Office européen des brevets**

(11) Numéro de publication : **0 432 683 B1**

## (12) FASCICULE DE BREVET EUROPEEN

(45) Date de publication du fascicule du brevet :
**13.09.95 Bulletin 95/37**

(51) Int. Cl.⁶ : **H03D 3/24**

(21) Numéro de dépôt : **90123681.0**

(22) Date de dépôt : **10.12.90**

(54) **Démodulateur à boucle de phase.**

(30) Priorité : **15.12.89 FR 8916621**

(43) Date de publication de la demande :
**19.06.91 Bulletin 91/25**

(45) Mention de la délivrance du brevet :
**13.09.95 Bulletin 95/37**

(84) Etats contractants désignés :
**CH DE ES FR GB IT LI**

(56) Documents cités :
**GB-A- 2 007 445**
**US-A- 3 710 261**
**US-A- 3 909 735**
**PATENT ABSTRACTS OF JAPAN, vol. 10, no. 24 (E-377)[2081], 30 janvier 1986; & JP-A-60 182 820**
**PATENT ABSTRACTS OF JAPAN, vol. 9, no. 277 (E-355)[2000], 6 novembre 1985; & JP-A-60 120 619**

(73) Titulaire : **ALCATEL ESPACE**
**11, avenue Dubonnet**
**F-92407 Courbevoie Cédex (FR)**

(84) **DE ES FR GB IT**
Titulaire : **ALCATEL N.V.**
**Strawinskylaan 341,**
**(World Trade Center)**
**NL-1077 XX Amsterdam (NL)**

(84) **CH LI**

(72) Inventeur : **Noguera, Christian**
**5, rue Georges Bidault**
**F-31400 Toulouse (FR)**
Inventeur : **Triaud, Pascal**
**8, rue de l'Isère**
**F-31170 Tournefeuille (FR)**
Inventeur : **Foucher, Jean-Luc**
**120 Chemin de la Longue**
**F-31600 Seysses (FR)**

(74) Mandataire : **Weinmiller, Jürgen et al**
**Lennéstrasse 9**
**Postfach 24**
**D-82336 Feldafing (DE)**

## Description

L'invention concerne un démodulateur à boucle de phase .

Le manuel de Floyd et Gardner intitulé "Phaselock techniques (deuxième édition ; pages 182-183) décrit un démodulateur à boucle de phase de l'art connu qui comprend un filtre passe-bande d'entrée, une boucle de phase comportant un détecteur de phase, un filtre de boucle, un VCO("Voltage Control Oscillator") ; un filtre de désaccentuation étant disposé en sortie de la boucle de phase.

Dans une telle boucle de phase, tout décalage entre la fréquence (Fe) de la porteuse à démoduler et la fréquence de repos du VCO $(Fvco)_o$, qui peut être dû à un vieillissement du VCO, une dérive de la porteuse..., produit une erreur de phase statique en sortie du comparateur de phase de la boucle, ce qui se traduit par :
- une dégradation du seuil du démodulateur ;
- une plus grande sensibilité au phénomène de "clicks".

JP-A 60 182 820 et JP-A 60 120 619 ont déjà proposé des solutions pour réduire cet erreur de phase statique.

L'invention a pour objet de pallier de tels inconvénients.

Elle propose, à cet effet, un démodulateur à boucle de phase comportant une boucle de phase primaire et une boucle secondaire, caractérisé en ce qu'il comprend un circuit de détection de l'accrochage de la boucle primaire qui, une fois l'accrochage détecté, commande la mise en service de la boucle secondaire, cette boucle participant à l'augmentation du gain continu de la boucle de phase primaire.

Avantageusement l'invention permet, de façon simple, de diminuer l'erreur de phase statique en sortie du comparateur de la boucle de phase : Elle permet en effet de maintenir les performances de la boucle de phase lorsque, suite à plusieurs causes telles que variation de température, vieillissement, radiations, il y a décalage entre la porteuse et le VCO, dans les limites de la bande d'acquisition.

Elle permet d'augmenter le gain de boucle continu en régime établi, une fois l'accrochage détecté.

Les caractéristiques et avantages de l'invention ressortiront d'ailleurs de la description qui va suivre, à titre d'exemple non limitatif, en référence aux figures annexées sur lesquelles :
- la figure 1 illustre schématiquement un démodulateur de l'art antérieur ;
- la figure 2 illustre le démodulateur selon l'invention.
- la figure 3 représente les performances en démodulation du démodulateur de l'art antérieur et du démodulateur de l'invention.

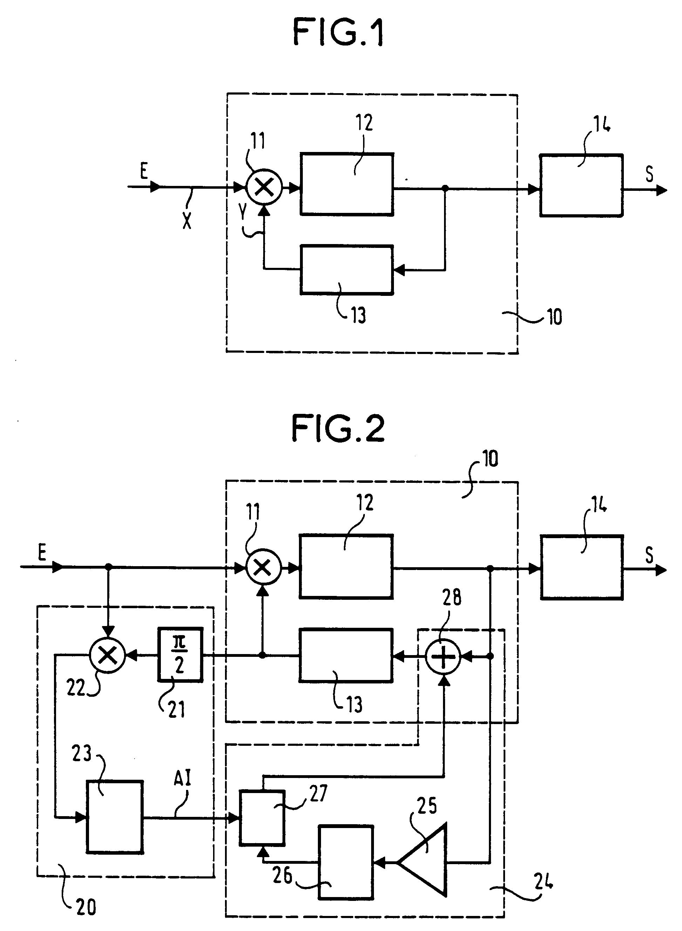

Le démodulateur de l'art connu, représenté sur la figure 1, comprend une boucle de phase 10 et un intégrateur de sortie 14 ; la boucle de phase 10 comprenant un comparateur de phase 11, un filtre de boucle 12, un VCO 13 rebouclé sur le comparateur de phase ; l'intégrateur de sortie 14 étant relié à la sortie du filtre de boucle 12.

Un comparateur de phase est un dispositif non linéaire et son fonctionnement optimum correspond à une utilisation à erreur de phase statique nulle.

Si l'on considère un comparateur 11 de gain Kd et un VCO 13 de pente Ko et des signaux d'entrée du comparateur 11 :

$$X = A \sin [ \omega ot + \varphi e(t)]$$
$$Y = B \cos [ \omega ot + \varphi s(t)]$$

on a la fonction de transfert suivante :
avec
$\varphi d$            : phase du signal démodulé
$\varphi e$            : phase du signal d'entrée.
B              : bande d'acquisition

$$\frac{\varphi d}{\varphi e} = \frac{Kd\, F(p)}{p + Ko\, Kd\, F(p)}$$

$$B = \frac{KT}{2\pi} \sqrt{2\, f1/f2}$$

avec

$$F(p) = F(o).\frac{1 + \tau 2\, p}{1 + \tau 1 p}$$
$$KT = Ko\, Kd.F(o)$$

f1 (= $1/\tau 1$) et f2 (= $1/\tau 2$) étant les pôles du filtre de boucle 12.

L'erreur de phase statique $\Delta \varphi$ dûe à un écart de fréquence entre Fe et $(Fvco)_o$ est donnée par :

$$\Delta \varphi = \frac{Fe - (Fvco)_o}{KT}$$

La valeur de KT est limitée par :

EP 0 432 683 B1

- la difficulté de réaliser des amplificateurs grand gain - large bande ;
- les sensibilités du comparateur de phase et du VCO.

Le démodulateur de l'invention, tel que représenté sur la figure 2 comprend les mêmes circuits de base que le démodulateur de l'art antérieur ; ces circuits sont donc représentés avec les mêmes références : soient la boucle de phase 10 et l'intégrateur de sortie 14.

Il comprend de plus un circuit de détection d'accrochage 20 qui comporte un déphaseur de $\pi/2$ (21) relié à la sortie du VCO 13, suivi d'un comparateur de phase 22 dont la seconde entrée est reliée à l'entrée E du démodulateur, et dont la sortie est reliée à un filtre passe-bas 23 qui délivre un signal indicateur d'accrochage AI.

Il comprend, en outre, une seconde boucle de phase dite "secondaire" 24, reliée à la sortie du filtre de boucle 12, qui comporte un amplificateur 25 suivi d'un filtre passe-bas 26, et d'un interrupteur 27 relié à un sommateur 28 qui est intercalé dans la boucle primaire 10 entre le filtre de boucle 12 et le VCO 13 ; cet interrupteur 27 étant commandé par le signal indicateur d'accrochage AI issu du circuit de détection d'accrochage 20.

L'invention permet de réduire le terme d'erreur de phase $\Delta \varphi$, lorsque la boucle est accrochée.

Avant accrochage, l'interrupteur 27 est ouvert et la boucle secondaire 24 n'est pas en service. On est ramené à la boucle de phase classique de la figure 1. La bande d'acquisition s'exprime par la formule explicitée précédemment :

$$B = \frac{KT}{2\pi} \sqrt{2\,f1\,f2}$$

Après accrochage, la porteuse et la sortie du VCO 13 sont en quadrature, le maximum de détection est obtenu en sortie du circuit de détection d'accrochage 20. L'interrupteur 27 rend alors la boucle secondaire 24 opérationnelle ; cette boucle étant constituée d'un amplificateur 25 de gain G et d'un filtre passe-bas 26 : la fréquence de coupure fc de ce filtre étant très faible (quelques Hertz) pour ne pas ramener un pôle parasite dans la boucle.

On a alors :

$$\frac{\varphi d}{\varphi e} = \frac{Kd\,F(p)}{p + Ko\,Kd\,F(p)\,[1 + G(p)]}$$

Pour les fréquences de modulation beaucoup plus élevées que la fréquence fc (en pratique f modulation > 10 x fc), les performances de démodulation sont celles de la boucle de phase primaire puisque $G(p) \simeq O$.

Le gain de boucle continu total est : KT [1+G(O)].

L'expression de l'erreur de phase statique devient :

$$\Delta \varphi = \frac{Fe - Fvco}{KT\,[1 + G(O)]}$$

et $\Delta \varphi$ avec boucle secondaire $= \dfrac{\Delta \varphi \text{ sans boucle secondaire}}{1 + G(O)}$

le gain sur l'erreur de phase statique est donc 1/[1+G(o)]

Des mesures de performances en démodulation ont été faites en simulant des écarts entre Fe et $(Fvco)_o$. Dans les conditions suivantes :

Fe - $(Fvco)_o$ = 1000 KHz,

G(O) = 40 et fc = 10 Hz,

La boucle primaire s'accroche en environ 10 $\mu$ s ; la boucle de phase secondaire accroche en quelques centaines de millisecondes. L'extension sur le seuil du démodulateur est de l'ordre de 2.2 dB.

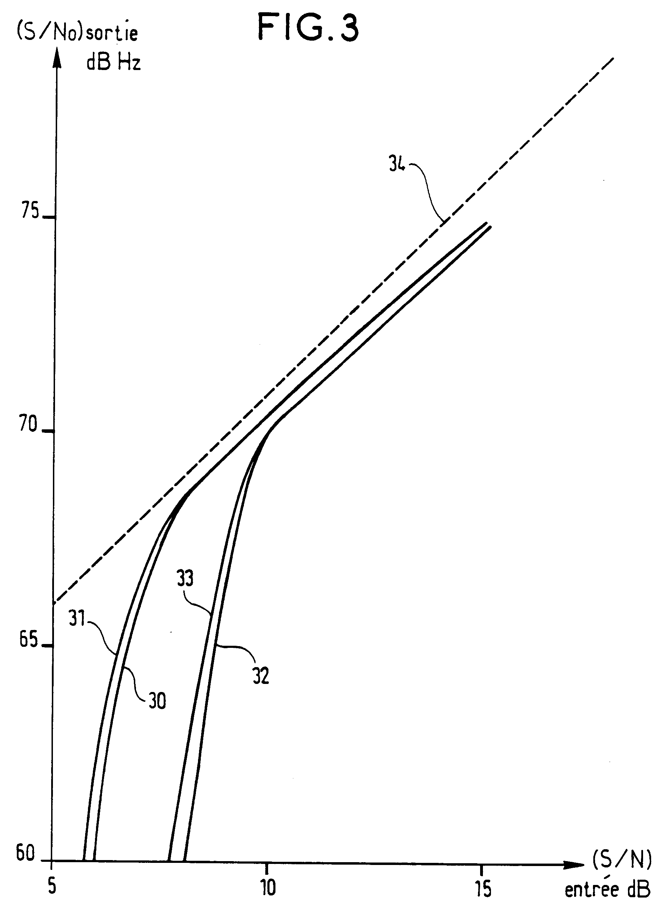

Les courbes 30, 31, 32 et 33 représentées à la figure 3 montrent les performances en démodulation de la boucle de phase classique représentée à la figure 1 et de la boucle de phase selon l'invention, lorsque l'écart entre la porteuse à démoduler et la fréquence de repos du VCO est voisine de $\pm$ 1 MHz : Les courbes 30 et 31 correspondant au démodulateur de phase selon l'invention, les courbes 32 et 33 au démodulateur classique.

Sur cette figure 3 les courbes 30 et 32 correspondent à 139 MHz. Les courbes 31 et 33 correspondent à 141 MHz avec une fréquence de modulation fm de 8 KHz et un indice de modulation de phase m de 1,2 rd. La courbe 34 étant la droite théorique correspondant à un démodulateur de phase idéal.

L'amélioration sur le seuil (défini par le point de compression à 1 dB) est de l'ordre de 2,2 dB.

L'invention permet donc une réduction de l'erreur de phase statique $\Delta \varphi$ par la mise en service, après accrochage, de la boucle secondaire 24 (Contrôle Automatique de Fréquence) qui participe à l'augmentation du gain continu de la boucle de phase primaire sans changer les paramètres : bande de boucle $\omega$n et amortissement, vis-à-vis de la modulation ; les performances à l'accrochage (bande d'acquisition) étant conservées.

Le dispositif de l'invention équipe les récepteurs de poursuite, télémesure et télécommande (ou TTC "Tracking Telemetry and command") de type EUTELSAT II et TELECOM II.

Il est bien entendu que la présente invention n'a été décrite et représentée qu'à titre d'exemple préférentiel

3

EP 0 432 683 B1

et que l'on pourra remplacer ses éléments constitutifs par des éléments équivalents sans, pour autant, sortir du cadre de l'invention.

**Revendications**

1. Démodulateur à boucle de phase comportant une boucle de phase primaire (10) et une boucle secondaire (24), caractérisé en ce qu'il comprend un circuit (20) de détection de l'accrochage de la boucle primaire (10) qui, une fois l'accrochage détecté, commande la mise en service de la boucle secondaire (24), cette boucle (24) participant à l'augmentation du gain continu de la boucle de phase primaire (10).

2. Démodulateur selon la revendication 1, caractérisé en ce que la boucle secondaire (24), reliée à la sortie du filtre de boucle (12), comporte un amplificateur (25) suivi d'un filtre passe-bas (26), d'un interrupteur (27) relié à un sommateur (28) qui est intercalé dans la boucle primaire entre le filtre de boucle (12) et le VCO (13) ; cet interrupteur (27) étant commandé par le signal indicateur d'accrochage (AI) issu du circuit de détection d'accrochage (20).

3. Démodulateur selon la revendication 1, caractérisé en ce que la boucle de phase primaire (10) comprend un comparateur de phase (11), un filtre de boucle (12) et un VCO (13) rebouclé sur le comparateur de phase.

4. Démodulateur selon la revendication 3, caractérisé en ce qu'il comprend une boucle de phase primaire (10) suivie d'un intégrateur de sortie (14).

5. Démodulateur selon la revendication 1, caractérisé en ce que le circuit de détection d'accrochage (20) comporte un déphaseur de $\pi/2$ (21) relié à la sortie du VCO (13) suivi d'un comparateur de phase (22) dont la seconde entrée est reliée à l'entrée (E) dudit démodulateur et dont la sortie est reliée à un filtre passe-bas (23) qui délivre un signal indicateur d'accrochage (IA).

**Patentansprüche**

1. Demodulator mit Phasenschleife, der eine erste Phasenschleife (10) und eine zweite Phasenschleife (24) aufweist, dadurch gekennzeichnet, daß er eine Schaltung (20) zur Erfassung des Einrastens der ersten Schleife (10) aufweist, die, wenn das Einrasten erfaßt wurde, die Inbetriebnahme der zweiten Schleife (24) steuert, wobei diese Schleife (24) zur Erhöhung des Gleichstromverstärkungsgrads der ersten Schleife (10) beiträgt.

2. Demodulator nach Anspruch 1, dadurch gekennzeichnet, daß die zweite Schleife (24), die mit dem Ausgang des Schleifenfilters (12) verbunden ist, hintereinander einen Verstärker (25), einen Tiefpaßfilter (26), einen Schalter (27) und einen Summierer (28) aufweist, der in die erste Schleife zwischen das Schleifenfilter (12) und den VCO (13) eingefügt ist und von dem Signal der Anzeige des Einrastens (AI) gesteuert wird, das aus dem Schaltkreis der Erfassung des Einrastens (20) kommt.

3. Demodulator nach Anspruch 1, dadurch gekennzeichnet, daß die erste Phasenschleife (10) eine Phasenkomparator (11), ein Schleifenfilter (12) und eine VCO (13) aufweist, der auf den Phasenkomparator rückgeschleift ist.

4. Demodulator nach Anspruch 3, dadurch gekennzeichnet, daß er einer erste Phasenschleife (10) gefolgt von einem Ausgangsintegrator (14) aufweist.

5. Demodulator nach Anspruch 1, dadurch gekennzeichnet, daß der Schaltkreis zur Erfassung des Einrastens (20) einen $\pi/2$-Phasenschieber (21) aufweist, der mit dem Ausgang des VCO (13) verbunden ist und zu einem Phasenkomparator (22) führt, dessen zweiter Eingang mit dem Eingang (E) des Demodulators und dessen Ausgang mit einem Tiefpaßfilter (23) verbunden ist, das ein Signal zur Anzeige des Einrastens (AI) liefert.

4

**Claims**

1.  A phase loop demodulator comprising a primary phase loop (10) and a secondary loop (24), the demodulator being characterized in that it includes a circuit (20) for detecting primary loop locking, and which, once locking has been detected, switches on said secondary loop (24), said secondary loop (24) participating in increasing the DC gain of the primary phase loop (10).

2.  A demodulator according to claim 1, characterized in that the secondary loop (24) is connected to the output of the primary loop (11) and includes an amplifier (25) followed by a lowpass filter (26), and a switch (27) connected to a summing circuit (28) which is interposed in the primary loop between the loop filter (12) and the VCO (13), said switch (27) being controlled by the signal (AI) delivered by the locking detector circuit (20) to indicate locking has occurred.

3.  A demodulator according to claim 1, characterized in that the primary phase loop (10) comprises a phase comparator (11), a loop filter (12), and a VCO (13) looped back to the phase comparator.

4.  A demodulator according to claim 3, characterized in that it includes a primary phase loop (10) followed by an output integrator (14).

5.  A demodulator according to claim 1, characterized in that the locking detector circuit (20) includes a $\pi/2$ phase shifter (21) connected to the output of the VCO (13) followed by a phase comparator (22) whose second input is connected to the input (E) of said demodulator and whose output is connected to a lowpass filter (23) which delivers a lock-indicating signal (AI).

# FIG.1

# FIG.2

FIG.3